# FASCICULE DE BREVET EUROPEEN

(11) **EP 0 403 330 B1**
(45) Date de publication et mention de la délivrance du brevet: **01.12.1993**
(21) Numéro de dépôt: 90401447.9
(22) Date de dépôt: 31.05.1990
(51) Int. Cl.: G01R 21/00

(54) **Circuit d'entrée pour compteur d'énergie électrique**
Eingangsschaltung für Elektrizitätszähler
Input circuit for electric energy meter

(30) Priorité: 16.06.1989 FR 8907998
(43) Date de publication de la demande: 19.12.1990
(73) Titulaire: SCHLUMBERGER INDUSTRIES, F-92120 Montrouge (FR)
(72) Inventeur: Carnel, Alain, F-86000 Poitiers (FR); Gourc, René, F-86000 Poitiers (FR); Kodras, Rudolph, A-1190 Wien (AT)
(74) Mandataire: Bentz, Jean-Paul

(56) Documents cités:
- EP-A- 0 044 528
- US-A- 3 226 641
- PATENT ABSTRACTS OF JAPAN vol. 7, no. 62 (E-164)(1207) 15 mars 1983, & JP-A-57 207412 (FUJITSU K.K.) 20 décembre 1982,
- IEEE TRANSACTIONS ON MAGNETICS. vol. MAG-7, no. 3, septembre 1971, NEW YORK US pages 438 - 442; D.R. HAMBURG ET AL.: "AN ELECTRONIC WATTMETER FOR NONSINUSOIDAL LOW POWER FACTOR POWER MEASUREMENTS"
- PATENT ABSTRACTS OF JAPAN vol. 7, no. 94 (E-171)(1239) 20 avril 1983, & JP-A-58 019015 (NIPPON DENKI K.K.) 03 février 1983,

## Description

La présente invention concerne un circuit d'entrée pour un organe de comptage propre à mesurer l'énergie électrique associée à des signaux de tension et de courant, comprenant un capteur de tension recevant le signal de tension, un capteur de courant recevant le signal de courant, et des voies de tension et de courant respectives pour relier ces capteurs à des entrées respectives de l'organe de comptage, circuit dans lequel le capteur de courant prend la forme d'un transformateur à inductance mutuelle et dans lequel la voie courant comprend un filtre actif déphaseur utilisant un amplificateur à deux entrées et une sortie, cet amplificateur étant associé d'une part à une résistance de réglage de gain en courant alternatif, qui est montée en amont de la première entrée de cet amplificateur, et d'autre part à liaison de rétroaction, incluant une capacité de rétroaction, grâce à laquelle la sortie de cet amplificateur est rebouclée sur la première entrée de ce dernier.

Par "résistance de réglage de gain", la présente description désigne toute résistance dont la modification entraînerait une modification de gain, et non pas spécifiquement une résistance particulière effectivement modifiée pour ajuster le gain.

Un tel circuit d'entrée est par exemple décrit dans le brevet américain US 3 226 641, délivré en 1965. EP 0044528 decrit un autre dispositif de mesure de la puissance électrique y compris un circuit déphaseur.

Comme le sait l'homme de l'art, et ainsi que le rappelle ce brevet antérieur, l'utilisation d'un transformateur à mutuelle inductance en tant que capteur de courant pour un compteur d'énergie électrique pose un problème particulier en ce sens que le signal disponible au secondaire d'un tel transformateur n'est pas une image du signal appliqué au primaire, mais seulement une image de la dérivée de ce signal en fonction du temps.

Il est connu de pallier cette difficulté en interposant sur la voie courant un filtre actif déphaseur qui, selon l'enseignement du brevet précité, est constitué par un intégrateur.

Cependant, cette solution pose à son tour un nouveau problème, rendu particulièrement aigu aujourd'hui par l'accroissement considérable des exigences de précision pesant sur les compteurs d'énergie électrique de type électronique, à savoir que l'intégrateur est lui-même susceptible d'introduire un signal continu parasite, éventuellement capable d'altérer la mesure effectuée par le circuit de comptage.

De façon plus générale, les incontournables imperfections physiques des composants utilisés dans le circuit d'entrée, en particulier du transformateur à inductance mutuelle et du filtre actif, ont pour effet global que le signal restitué par le filtre actif ne constitue pas nécessairement une image fidèle du signal de courant à mesurer, surtout dans le cas où le filtre actif est un intégrateur traditionnel, donc affecté d'une tension de décalage (offset).

Dans ce contexte, un premier but de l'invention est de proposer un circuit d'entrée, pour un compteur d'énergie électrique, dont la fonction de transfert soit telle que ce circuit n'introduise aucun effet parasite dans le signal à mesurer.

A cette fin, le circuit de l'invention est essentiellement caractérisé en ce qu'en plus de la résistance de réglage de gain en courant alternatif, et de la capacité de rétroaction, le filtre actif déphaseur comprend une capacité de couplage qui est montée à la sortie de l'amplificateur, en amont de la liaison de rétroaction.

De préférence, le filtre actif comprend également une résistance de limitation de gain en courant continu reliant directement la sortie de l'amplificateur à la première entrée de ce dernier.

Dans ce dernier cas, on peut prévoir que le filtre actif comprenne en outre un premier filtre passif RC, de type intégrateur, monté en amont des deux entrées de l'amplificateur, de manière à compenser un écart entre le déphasage introduit par le filtre actif et une valeur prédéterminée, souhaitée pour ce déphasage.

Pour rendre le filtre actif encore plus insensible à la charge reliée à sa sortie, un diviseur de tension peut être monté à la sortie de ce filtre actif, en amont de cette charge.

Dans le circuit de l'invention, le capteur de tension n'a pas besoin d'être particulièrement élaboré et peut au contraire être tout simplement constitué par un diviseur de tension présentant une sortie reliée à une borne de jonction entre une première impédance recevant le signal de tension et une seconde impédance reliée à une tension de référence.

Pour une ultime correction d'erreur de phase du filtre actif, et dans l'application du circuit à un compteur d'énergie active, la première impédance de ce diviseur de tension peut cependant comprendre une capacité.

Dans une application du circuit à un compteur d'énergie électrique réactive, le filtre actif peut comprendre une résistance de fuite branchée en parallèle sur la capacité de rétroaction, ce filtre opérant alors un déphasage de 45 degrés.

Dans ce dernier cas, on peut également prévoir que la voie tension comprenne un second filtre passif RC, de type intégrateur, opérant lui aussi un déphasage de 45 degrés.

De préférence, une résistance est alors montée en parallèle sur la capacité du second filtre passif RC.

D'autres caractéristiques et avantages de l'invention ressortiront clairement de la description qui en est faite ci-après, à titre indicatif et nullement limitatif, en référence aux dessins annexés, parmi lesquels:
- la figure 1 est un schéma électrique représentant un mode de réalisation possible d'un circuit d'entrée conforme à l'invention, destiné à un compteur d'énergie active;
- la figure 2 est un schéma électrique représentant un mode de réalisation possible d'un circuit d'entrée conforme à l'invention, destiné à un compteur d'énergie réactive;
- la figure 3 est un diagramme représentant la réponse d'une portion du circuit de la figure 1, caractérisée par la phase relative d'un signal de sortie, portée en ordonnée, en fonction de la fréquence, portée en abscisse, d'un signal appliqué à l'entrée de cette portion de circuit; et
- la figure 4 est un diagramme représentant la réponse de cette même portion du circuit de la figure 1, caractérisée par la tension en volts d'un signal de sortie, portée en ordonnée, en fonction de la fréquence, portée en abscisse, d'un signal appliqué à l'entrée de cette portion de circuit.

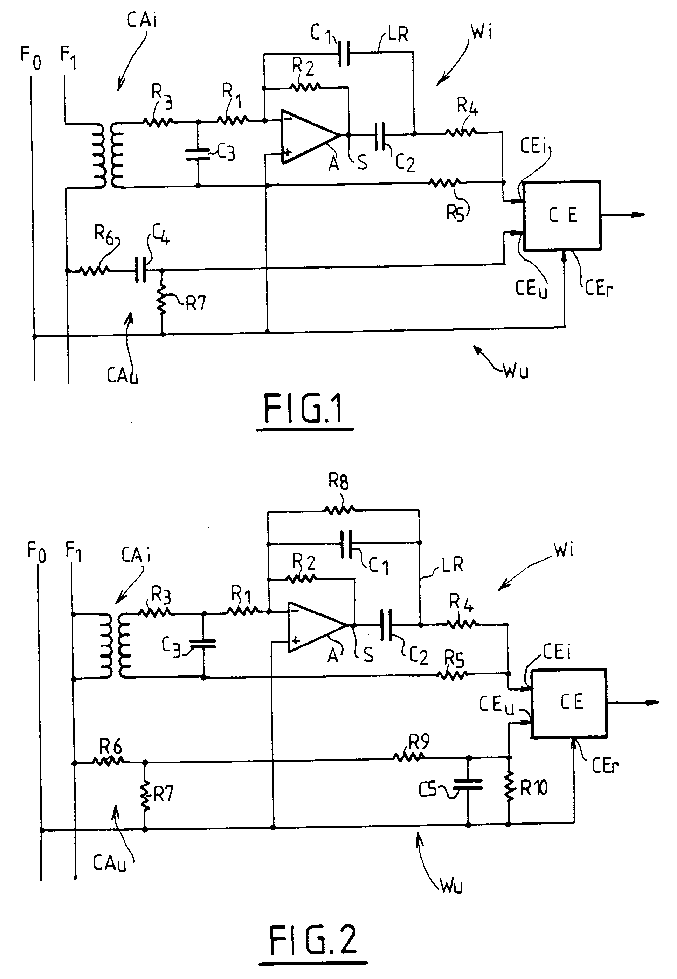

La figure 1 représente, en F0 et F1, deux conducteurs d'un réseau de distribution d'électricité, auxquels peuvent être reliées des charges (non représentées) susceptibles de consommer une certaine quantité d'énergie, que l'organe de comptage électronique CE a pour vocation de mesurer.

La quantité d'énergie recherchée dépend d'une part du courant circulant dans le conducteur F1 (ou dans le conducteur F0), et d'autre part de la tension existant entre les conducteurs F0 et F1.

Les signaux associés à ce courant et à cette tension sont détectés par des capteurs de courant et de tension respectifs CAi et CAu, qui en fournissent des signaux dérivés, et ces derniers sont transmis à des entrées respectives CEi et CEu de l'organe de comptage, à travers des voies de courant et de tension respectives, Wi et Wu.

Dans le cas considéré, le capteur de courant est un transformateur à inductance mutuelle, c'est-à-dire un transformateur essentiellement constitué par des enroulements primaire et secondaire à couplage électromagnétique direct dans l'air.

La voie courant Wi comprend un filtre actif déphaseur utilisant un amplificateur A comportant une entrée inverseuse A-, une entrée non inverseuse A+, et une sortie S.

Cet amplificateur est associé d'une part à une résistance de réglage de gain en courant alternatif R1, qui est montée en amont de l'entrée inverseuse A-, et d'autre part à une liaison de rétroaction LR sur laquelle est interposée une capacité de rétroaction C1, cette liaison rebouclant la sortie S de l'amplificateur sur l'entrée inverseuse de ce dernier.

Selon une caractéristique essentielle de l'invention, le filtre actif déphaseur comprend également une capacité de couplage C2, montée à la sortie de l'amplificateur, en amont de la liaison de rétroaction LR.

L'amplificateur A, en combinaison avec la résistance R1 et la capacité de rétroaction C1, constitue un intégrateur classique, connu pour opérer, sur tout signal alternatif appliqué sur la résistance R1, un déphasage de 90 degrés et une atténuation proportionnelle à la fréquence de ce signal, qui permettraient de façon simple, si des effets parasites indésirables ne venaient pas s'y ajouter, de compenser le déphasage et l'amplification de sens inverse introduits par le capteur CAi.

En revanche, l'amplificateur A combiné à la résistance R1 et aux capacités C1 et C2 cesse de se comporter comme un intégrateur traditionnel, la capacité C2 s'opposant à la circulation de courants de basse fréquence. Le comportement du filtre, relativement complexe, sera détaillé dans la suite de la description.

En plus des éléments déjà décrits, le filtre actif comprend de préférence une résistance de limitation de gain en courant continu R2, reliant directement la sortie de l'amplificateur A à l'entrée inverseuse de ce dernier, qui a pour effet positif d'éviter une auto-saturation de l'amplificateur par intégration de sa tension de décalage (offset) mais pour effet indésirable d'éloigner encore les caractéristiques du filtre actif A, R1, C1, R2, C2 de celles d'un intégrateur parfait.

Dans ces conditions, l'action de ce filtre ne compense plus, au moins dans une large gamme de fréquence, celle du transformateur à mutuelle inductance CAi qui constitue pour sa part un dérivateur pratiquement idéal, au moins pour les signaux dans le domaine des fréquences utiles.

Pour pallier cette difficulté, le filtre actif est de préférence doté d'un filtre passif RC de type intégrateur, constitué par la résistance R3 et la capacité C3, monté en amont des deux entrées A- et A+ de l'amplificateur A, ce filtre passif étant conçu pour donner au déphasage total de l'ensemble A, C1, C2, C3, R1, R2, R3 une valeur égale à 90 degrés dans son application, qui est celle considérée en référence à la figure 1, à un organe de comptage d'énergie active.

En plus de sa fonction de rattrapage d'erreur de déphasage, ce filtre passif R3C3 a pour effet positif d'amortir les ondes transitoires haute fréquence d'amplitude élevée que peut engendrer le capteur de courant en raison de ses caractéristiques de dérivateur.

Pour rendre le filtre actif plus insensible à la charge externe à laquelle il est raccordé, et pour réduire au maximum la taille et la valeur de la capacité C2, il peut être avantageux de monter un diviseur de tension tel que R4, R5, à la sortie du filtre actif A, R1, C1, C2, R2.

Le capteur de tension peut, de façon simple, comprendre un diviseur de tension présentant une sortie reliée à une borne de jonction entre une première impédance R6C4 recevant le signal de tension et une seconde impédance R7 reliée à une tension de référence.

Dans ce cas, une éventuelle erreur résiduelle du déphasage introduit par le filtre actif, représentée par une évolution de la phase en fonction de la fréquence, peut être compensée en réalisant la première impédance sous la forme d'une résistance et d'une capacité montées en série, la seconde impédance étant de nature purement résistive.

Le potentiel de référence commun aux voies de courant et de tension Wi et Wu, ainsi qu'à l'organe de comptage CE, est par exemple le potentiel du conducteur neutre F0, auquel sont donc raccordés la capacité C3, l'entrée non-inverseuse A+ de l'amplificateur A, la résistance R5, la résistance R7 et l'entrée de potentiel de référence CEr de l'organe de comptage CE.

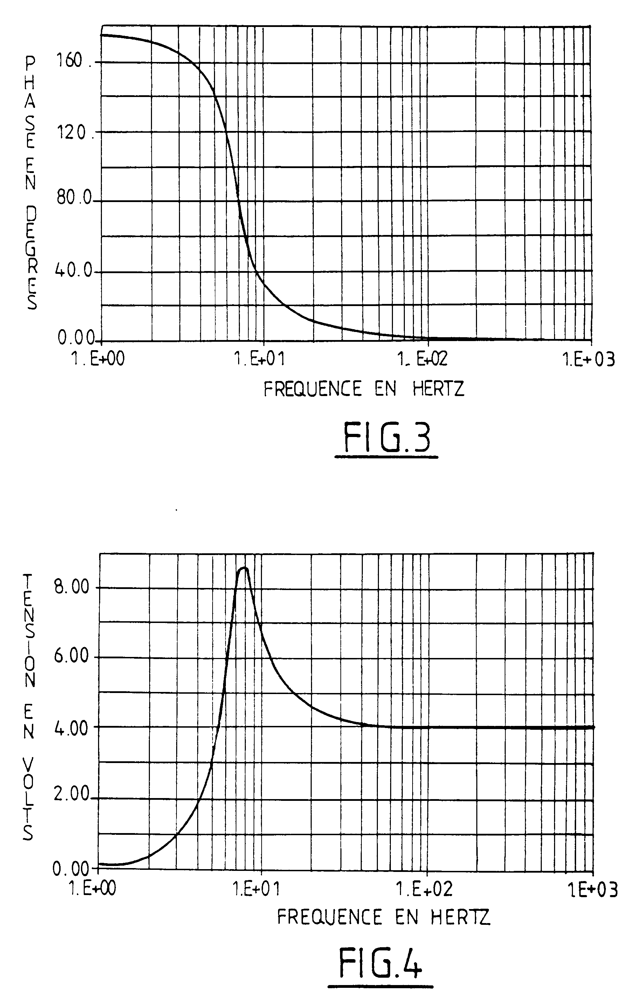

Les figures 3 et 4 se rapportent à la fonction de transfert globale de la combinaison du capteur de courant CAi d'une part et du filtre actif A, R1, C1, R2, C2 d'autre part, le filtre passif R3C3 étant exclu de cette combinaison.

Comme le montre la figure 3, cette combinaison se comporte presque comme un inverseur de polarité pour les signaux dont la fréquence est de l'ordre de 1 Hz, comme un déphaseur de 90 degrés pour les signaux dont la fréquence est de l'ordre de 7 Hz, et comme un déphaseur dont l'effet tend vers zéro à partir d'une fréquence des signaux de l'ordre de 50 Hz.

Corrélativement, la figure 4 montre que les signaux dont la fréquence est inférieure à 2 Hz ne sont pratiquement pas transmis, que les signaux dont la fréquence est de l'ordre de 7 Hz provoquent une résonnance qui les amplifie, et que les signaux, à partir d'une fréquence de l'ordre de 5O Hz, sont restitués sans altération de leur amplitude.

Les principes directeurs pour la réalisation pratique détaillée du circuit de la figure 1 sont les suivants.

La résistance R1 doit avoir une valeur élevée par rapport à celle de la résistance de l'enroulement secondaire du capteur de courant CA1, et par exemple valoir au moins 100 fois cette dernière. Une valeur possible en pratique est 78 800 ohms.

La capacité C1 vaut par exemple 10 nF tandis que C2 est de l'ordre de 2.2.10⁻⁶ farads.

La valeur de la résistance R2 doit être fixée à une valeur élevée, 4.7.10⁶ ohms par exemple, tandis que les résistances R4 et R5 ont des valeurs respectives possibles de l'ordre de 3000 et 2000 ohms.

Si R4 est choisie avec une valeur plus petite, il convient de choisir C1 avec une valeur plus grande, de manière que le produit (R4+R5).C1 reste sensiblement constant.

La résistance R3 et la capacité C3 ont des valeurs respectives possibles de 78 800 ohms et 1.2 nF.

La résistance R6, la résistance R7, et la capacité C4 ont des valeurs respectives possibles de 392 000 ohms, 2600 à 4000 ohms, et 68 nF.

La figure 2 décrit un circuit analogue au circuit de la figure 1, à ceci près qu'il est destiné à un organe de comptage d'énergie réactive.

Cette application a pour corollaire que le déphasage relatif des signaux de tension et de courant fournis aux entrées CEi et CEu de l'organe de comptage CE diffère de 90 degrés du déphasage relatif des signaux de tension et de courant disponibles sur les conducteurs F0 et F1.

Comme le capteur de courant CAi introduit par lui-même une rotation de phase de 90 degrés sur le signal de courant et une amplification proportionnelle à la fréquence de ce signal, les voies de tension et de courant Wu et Wi ne sont a priori soumises à aucune autre contrainte que d'introduire le même déphasage, éventuellement nul, dans les signaux qu'elles transmettent et une atténuation des signaux de courant et de tension qui compense l'amplification, proportionnelle à leur fréquence, introduite par le capteur CAi sur le signal de courant.

La solution de l'invention consiste en fait à faire en sorte que les voies tension et courant introduisent chacune un déphasage de 45 degrés et une atténuation corrélative du signal correspondant, dont l'amplitude est ainsi, au moins approximativement, rendue proportionnelle à la racine carrée de l'inverse de la fréquence commune des signaux de courant et de tension, les atténuations des deux voies compensant ainsi, pour le signal représentatif de l'énergie réactive délivré par l'organe de comptage CE, l'amplification proportionnelle à la fréquence introduite par le capteur de courant CAi.

Les éléments remplissant des fonctions homologues dans les circuits des figures 1 et 2 sont repérés sur ces dernières avec des chiffres de référence identiques.

Ainsi, outre les éléments déjà présentés dans la description de la figure 1, le circuit de la figure 2 fait apparaître une résistance de fuite R8 branchée en parallèle sur la capacité de rétroaction C1 et dont la fonction est de modifier jusqu'à la valeur de 45 degrés le déphasage introduit par le filtre actif A, R1, C1, R2, C2, R3, C3.

La voie tension Wu comprend toujours essentiellement un diviseur de tension R6, R7, propre à abaisser sensiblement la tension disponible entre les conducteurs F0 et F1.

Hormis de ces éléments, cette voie comprend aussi un second filtre passif RC, de type intégrateur, composé de la résistance en série R9 et de la capacité en parallèle C5, ce filtre introduisant lui aussi un déphasage de 45 degrés.

De préférence, comme représenté sur la figure 2, une résistance R10 peut être montée en parallèle sur la capacité C5 de manière à réduire la tension sur cette dernière.

Comme le comprendra aisément l'homme de l'art, les composants R6, R7, R9, R10 et C5 pourront être combinés par des calculs connus d'impédances équivalentes, de manière à en réduire le nombre si nécessaire.

Dans le montage de la figure 2, la voie courant Wi et la voie tension Wu introduisent, sur les signaux de courant et de tension respectifs, une amplification sensiblement proportionnelle à la racine carrée de l'inverse de la fréquence commune de ces signaux.

La contribution conjointe des voies de tension et de courant se traduit donc, pour le signal représentatif de l'énergie, par une atténuation qui compense, quelle que soit la fréquence des signaux de courant et de tension, au moins dans un certain domaine autour de leur fréquence nominale, l'amplification introduite par le capteur de courant CAi.

De plus, dans la mesure où les voies de tension Wu et de courant Wi sont conçues pour introduire le même déphasage de 45 degrés, et où les variations de fréquence des signaux de courant et de tension n'affectent pas sensiblement l'identité des déphasages introduits par les voies courant et tension, le montage de la figure 2 présente, par rapport aux montages connus, l'avantage de compenser à la fois les erreurs de phase et les erreurs d'amplitude qui apparaîtraient normalement pour des variations de fréquence, autour de leur valeur nominale commune, des signaux de courant et de tension disponibles sur les conducteurs F0 et F1.

## Revendications

1. Circuit d'entrée pour un organe de comptage propre à mesurer l'énergie électrique associée à des signaux de tension et de courant, comprenant un capteur de tension (CAu) recevant le signal de tension, un capteur de courant (CAi) recevant le signal de courant, et des voies de tension et de courant (Wu,Wi) respectives pour relier ces capteurs à des entrées respectives de l'organe de comptage, circuit dans lequel le capteur de courant (CAi) prend la forme d'un transformateur à inductance mutuelle et dans lequel la voie courant (Wi) comprend un filtre actif déphaseur utilisant un amplificateur (A) à deux entrées et une sortie, cet amplificateur étant associé d'une part à une résistance de réglage de gain en courant alternatif (R1), qui est montée en amont de la première entrée de cet amplificateur, et d'autre part à une liaison de rétroaction (LR), incluant une capacité de rétroaction (C1), grâce à laquelle la sortie de cet amplificateur est rebouclée sur la première entrée de ce dernier, caractérisé en ce que le filtre actif déphaseur comprend en outre une capacité de couplage (C2) montée à la sortie de l'amplificateur, en amont de la liaison de rétroaction (LR).

2. Circuit suivant la revendication 1, caractérisé en ce que le filtre actif comprend une résistance de limitation de gain (R2) en courant continu reliant directement la sortie de l'amplificateur à la première entrée de ce dernier.

3. Circuit suivant la revendication 2, caractérisé en ce que le filtre actif comprend un filtre passif RC (R3,C3), de type intégrateur, monté en amont de deux entrées de l'amplificateur, de manière à compenser un écart entre le déphasage introduit par le filtre actif et une valeur prédéterminée, souhaitée pour ce déphasage.

4. Circuit suivant l'une quelconque des revendications précédentes, caractérisé en ce qu'un diviseur de tension (R4,R5) est monté à la sortie du filtre actif.

5. Circuit suivant l'une quelconque des revendications précédentes, caractérisé en ce que le capteur de tension comprend un diviseur de tension présentant une sortie reliée à une borne de jonction entre une première impédance (R6,C4) recevant le signal de tension et une seconde impédance (R7) reliée à une tension de référence.

6. Circuit suivant la revendication 5, caractérisé en ce que la première impédance comprend une capacité (C4).

7. Circuit suivant l'une quelconque des revendications 1 à 5, caractérisé en ce que, pour opérer un déphasage de 45 degrés, le filtre actif comprend une résistance de fuite (R8) branchée en parallèle sur la capacité de rétroaction (C1), ce circuit étant destiné à un compteur d'énergie électrique réactive.

8. Circuit suivant la revendication 7, caractérisé en ce que la voie tension comprend un second filtre passif RC (R9,C5), de type intégrateur, opérant lui aussi un déphasage de 45 degrés.

9. Circuit suivant la revendication 8, caractérisé en ce qu'une résistance (R10) est montée en parallèle sur la capacité (C5) du second filtre RC.

## Patentansprüche

1. Eingangsschaltung für eine Zähleinrichtung, die dazu geeignet ist, die mit Spannungs- und Stromsignalen in Beziehung stehende elektrische Energie zu messen, mit einem Spannungsfühler (CAi), der das Spannungssignal empfängt, einem Stromfühler (CAi), der der Stromsignal empfängt, und entsprechenden Spannungs- und Strompfaden (Wu, Wi), um diese Fühler mit entsprechenden Eingängen der Zähleinrichtung zu verbinden, wobei in der Schaltung der Stromfühler (CAi) die Form eines Transformators mit Gegeninduktivität hat und der Strompfad (Wi) ein aktives Phasenverschiebungsfilter enthält, das einen Verstärker (A) mit zwei Eingängen und einem Ausgang verwendet, wobei dieser Verstärker einerseits mit einem Wechselstromverstärkungs-Einstellwiderstand (R1) verbunden ist, der stromaufseitig zum ersten Eingang dieses Verstärkers angeordnet ist, und andererseits mit einer Rückkopplungsverbindung (LR), die eine Rückkopplungkapazität (C1) enthält, kraft derer der Ausgang dieses Verstärkers mit dem ersten Eingang dieses letzteren rückgekoppelt ist, dadurch gekennzeichnet, daß das aktive Phasenverschiebungsfilter außerdem eine Kopplungskapazität (C2) besitzt, die am Ausgang des Verstärkers stromaufseitig zur Rückkopplungsverbindung (LR) angeordnet ist.

2. Schaltung gemäß Anspruch 1, dadurch gekennzeichnet, daß das aktive Filter einen Gleichstromverstärkungs-Begrenzungswiderstand (R2) enthält, der den Ausgang des Verstärkers direkt mit dem ersten Eingang dieses letzteren verbindet.

3. Schaltung gemäß Anspruch 2, dadurch gekennzeichnet, daß das aktive Filter ein passives RC-Filter (R3, C3) vom Integratortyp enthält, das stromaufseitig zu den beiden Eingängen des Verstärkers angeordnet ist, derart, daß ein Abstand zwischen der vom aktiven Filter eingeführten Phasenverschiebung und einem für diese Phasenverschiebung gewünschten, vorgegebenen Wert kompensiert wird.

4. Schaltung gemäß einem der vorangehenden Ansprüche, dadurch gekennzeichnet, daß ein Spannungsteiler (R4, R5) am Ausgang des aktiven Filters angeordnet ist.

5. Schaltung gemäß einem der vorangehenden Ansprüche, dadurch gekennzeichnet, daß der Spannungsfühler einen Spannungsteiler enthält, der einen Ausgang aufweist, der mit einem Verbindungsanschluß zwischen einer das Spannungssignal empfangenden ersten Impedanz (R6, C4) und einer mit einer Referenzspannung verbundenen zweiten Impedanz (R7) verbunden ist.

6. Schaltung gemäß Anspruch 5, dadurch gekennzeichnet, daß die erste Impedanz eine Kapazität (C4) enthält.

7. Schaltung gemäß einem der Ansprüche 1 bis 5, dadurch gekennzeichnet, daß das aktive Filter zum Ausführen einer Phasenverschiebung von 45 Grad einen Nebenschlußwiderstand (R8) enthält, der zur Rückkopplungskapazität (C1) parallel geschaltet ist, wobei diese Schaltung für einen Blindelektroenergiezähler bestimmt ist.

8. Schaltung gemäß Anspruch 7, dadurch gekennzeichnet, daß der Spannungspfad ein zweites passives RC-Filter (R9, C5) vom Integratortyp enthält, das seinerseits eine Phasenverschiebung von 45 Grad ausführt.

9. Schaltung gemäß Anspruch 8, dadurch gekennzeichnet, daß zur Kapazität (C5) des zweiten RC-Filters ein Widerstand (R10) parallelgeschaltet ist.

## Claims

1. An input circuit for a meter unit suitable for measuring electrical energy associated with voltage and current signals, the input circuit comprising a voltage sensor (CAu) receiving the voltage signal, a current sensor (CAi) receiving the current signal, and respective voltage and current paths (Wu, Wi) for connecting said sensors to respective inputs of the meter unit, the current sensor (CAi) being in the form of a mutual inductance transformer and the current path (Wi) including a phase shifting active filter based on an amplifier (A) having two inputs and one output, said amplifier being associated firstly with an AC gain adjusting resistance (Ri) which is connected upstream from the first input of said amplifier, and secondly with a feedback connection (LR) including a feedback capacitance (C1), thereby looping the output of the amplifier back onto the first input thereof, the circuit being characterized in that the phase shifting active filter further includes a coupling capacitance (C2) connected to the output of the amplifier upstream from the feedback connection (LR).

2. A circuit according to claim 1, characterized in that the active filter includes a DC gain-limiting resistance (R2) directly connecting the output of the amplifier to the first input thereof.

3. A circuit according to claim 2, characterized in that the output filter comprises a passive RC filter (R3, C3) of the integrator type connected upstream from the two inputs to the amplifier, thereby compensating for a difference between the phase shift imparted by the active filter and a predetermined value desired for said phase shift.

4. A circuit according to any preceding claim, characterized in that a voltage divider (R4, R5) is connected to the output of the active filter.

5. A circuit according to any preceding claim, characterized in that the voltage sensor comprises a voltage divider having an output connected to the junction terminal between a first impedance (R6, C4) receiving the voltage signal and a second impedance (R7) connected to a reference voltage.

6. A circuit according to claim 5, characterized in that the first impedance includes a capacitance (C4).

7. A circuit according to any one of claims 1 to 5, characterized in that in order to provide a phase shift of 45°, the active filter comprises a leakage resistance (R8) connected in parallel with the feedback capacitance (C1), said circuit being intended for a reactive electrical energy meter.

8. A circuit according to claim 7, characterized in that the voltage path comprises a second passive RC filter (R9, C5) of the integrator type, likewise imparting a phase shift of 45°.

9. A circuit according to claim 8, characterized in that a resistance (R10) is connected in parallel with the capacitance (C5) of the second RC filter.
